# EUROPEAN PATENT SPECIFICATION

(11) **EP 2 400 313 B1**
(45) Date of publication and mention of the grant of the patent: **14.08.2013**
(21) Application number: 10166305.2
(22) Date of filing: 17.06.2010
(51) Int. Cl.: G01R 31/36

(54) **Method and arrangement for ensuring sufficient electrical power supply for different electrically powered vehicle systems**
Verfahren und Anordnung zur Sicherstellung einer ausreichenden Stromversorgung für verschiedene elektrisch betriebene Fahrzeugsysteme
Procédé et agencement pour assurer une alimentation électrique suffisante pour différents systèmes de véhicules électriques

(43) Date of publication of application: 28.12.2011
(73) Proprietor: Volvo Car Corporation, 405 31 Göteborg (SE)
(72) Inventor: Axelsson, Bengt, 42165, Västra Frölunda (SE); Antonsson, Anders, 42141, Västra Frölunda (SE); Lantz, Jonn, 41728, Göteborg (SE)
(74) Representative: Widahl, Jenny Marie

(56) References cited:
- EP-A1- 1 555 537
- EP-A1- 1 605 273
- EP-A1- 1 788 402
- EP-A1- 1 873 542
- EP-A2- 2 233 938
- DE-A1-102005 026 077
- DE-A1-102005 050 563
- US-A1- 2004 162 683
- US-A1- 2007 236 181
- US-A1- 2008 054 848
- US-B1- 6 441 586

## Description

### Technical field

The present invention relates to a method for measuring and predicting available electrical power supply in vehicles in accordance with the preamble of claim 1. The present invention further relates to an arrangement for measuring and predicting available electrical power supply in vehicles in accordance with the preamble of claim 6.

### Background of the invention

The number of functions in motor vehicles which are realized using electrical power has increased over the years. Provisions have been made to accommodate for this increased electrical power consumption through increasing the capacity of the vehicle batteries and/or through increasing the output electrical power of an alternator of the vehicle.

Electrical energy stored in a battery is a highly refined source of energy. Chemical energy in a fuel is at least partially converted to kinetic energy in an internal combustion engine, which internal combustion engine in turn may power an alternator, a thermoelectric converter, or similar, which produces electrical energy that is stored in the battery.

At each step of this chain there are energy losses that cause the energy stored in the battery to be only a fraction of the chemical energy which initially was available in the fuel. Also later, when one wishes to make use of the energy stored in the battery, there are losses in the battery, in the wiring and in electric motors/actuators.

In order to minimize the exhaust emissions and fuel consumption of vehicles today there have been identified more and more situations during operation of motor vehicles where one wishes to be able to avoid operating the internal combustion engine.

Consequently, there exist a conflict between the wish to be able to avoid operating the internal combustion engine and the need of ensuring sufficient electrical power supply for different electrically powered vehicle systems.

Furthermore, in pure electrical vehicles, plug-in hybrid vehicles and hybrid vehicles there are usually two different battery systems having different voltage levels, a low voltage system, e.g. 12V and a high voltage system, e.g. 400V. In vehicles in these kinds usually a DC/DC converter is utilized in order to charge the low voltage system from the high voltage system.

However, in vehicles of these kinds there exists a conflict between desires to be able to drive as far as possible using the high voltage system while at the same time ensuring sufficient electrical power supply for different vehicle systems electrically powered by the low voltage system.

There are known solutions attempting to address these conflicts. However, these known solutions are based on measurements performed at the energy reserve, i.e. the low voltage battery, which implies a number of sources of error, due to ageing of the energy reserve and the distribution system as well as temperature influence. As a result there is a need for large tolerances in the system in order to ensure availability of sufficient power supply at the load. These known solutions have a further deficiency in that they are unable to identify and isolate partial degradation of the system.

The document US2004/162683 A1 discloses a method and an apparatus for determining SOC and SOH of a battery system by providing a model including an equivalent circuit. Other documents disclosing battery modelling for measuring and/or predicting available electrical power supply in vehicles are EP 1 873 542 A1, US2008/0054848 A1, DE 10 2005 050 563 A1, EP 1 605 273 A1 and DE 10 2005 026 077 A1.

### Summary of the invention

One object of the invention is to provide a method to improve handling of the conflict between the wish to be able to avoid operating an internal combustion engine of a vehicle or desires to be able to drive a pure electrical vehicle, plug-in hybrid vehicle or a hybrid vehicle as far as possible using a high voltage system, while at the same time ensuring sufficient electrical power supply for different vehicle systems electrically powered by a low voltage system.

This object is achieved by means of a method for measuring and predicting available electrical power supply in vehicles having one or more electronic control units and associated electrical systems having the characteristics of claim 1.

Thanks to the provision of the steps of: modeling the complete electrical system outside the electronic control unit as a linear circuit with an ideal battery with voltage V and a serial resistance R; monitoring the electronic control unit voltage and electrical current including the loads controlled by the electronic control unit; continuously calculating the model control variables V and R using the monitored voltage and current; using the calculated model control variables V and R to extrapolate the electronic control unit voltage at present current Iₚᵣₑₛ to a current Iₘₐₓ corresponding to a predefined heavy load scenario; and, triggering a control signal if the extrapolated electronic control unit voltage drops below a certain acceptance threshold, this method makes it possible to ensure sufficient electrical power supply for different vehicle systems electrically powered by a low voltage system.

A further object of the invention is to provide an arrangement to improve handling of the conflict between the wish to be able to avoid operating an internal combustion engine of a vehicle or desires to be able to drive a pure electrical vehicle, plug-in hybrid vehicle or a hybrid vehicle as far as possible using a high voltage system, while at the same time ensuring sufficient electrical power supply for different vehicle systems electrically powered by a low voltage system.

This object is achieved by means of an arrangement for measuring and predicting available electrical power supply in vehicles having one or more electronic control units and associated electrical systems having the characteristics of claim 6.

Thanks to the provision of means for: modeling the complete electrical system outside the electronic control unit as a linear circuit with an ideal battery with voltage V and a serial resistance R; monitoring the electronic control unit voltage and electrical current including the loads controlled by the electronic control unit; continuously calculating the model control variables V and R using the monitored voltage and current; using the calculated model control variables V and R to extrapolate the electronic control unit voltage at present current Iₚᵣₑₛ to a current Iₘₐₓ corresponding to a predefined heavy load scenario; and, triggering a control signal if the extrapolated electronic control unit voltage drops below a certain acceptance threshold, this arrangement makes it possible to ensure sufficient electrical power supply for different vehicle systems electrically powered by a low voltage system.

Preferred embodiments are listed in the dependent claims.

### Description of drawings

In the following, the invention will be described in greater detail by way of example only with reference to attached drawings, in which
Fig. 1 is an example equivalent circuit diagram.
Fig. 2 is a diagram showing a prediction based on current or historical event in a short term perspective.
Fig. 3 is a diagram showing a prediction based on current or historical events in a medium short perspective.
Fig. 4 is a block schematic illustrating how predictions for several partial systems are arranged and creates several composite signals out, which permit or deny stopping of the internal combustion engine and also provide availability and diagnosis information.
Fig. 5 is a block schematic illustrating a communication bus system for transfer of information in a vehicle.
Fig. 6 illustrates how voltage and current consumption in a node is measured.
Fig. 7 illustrates how the inner resistance of the energy reserve is calculated based on many measurements during a longer period of time.

Still other objects and features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims. It should be further understood that the drawings are not necessarily drawn to scale and that, unless otherwise indicated, they are merely intended to conceptually illustrate the structures and procedures described herein.

### Description of embodiments

In overview, the present invention relates to the prediction of electrical energy in vehicles. In particular it relates to a method and arrangement for measuring and predicting available electrical power supply in vehicles having one or more electronic control units and associated electrical systems. The method is especially suited for prediction of whether charging of a low voltage battery of the vehicle through operation of an associated internal combustion engine having an alternator or from a high voltage vehicle battery may be interrupted or not based on instantaneous as well as historical information.

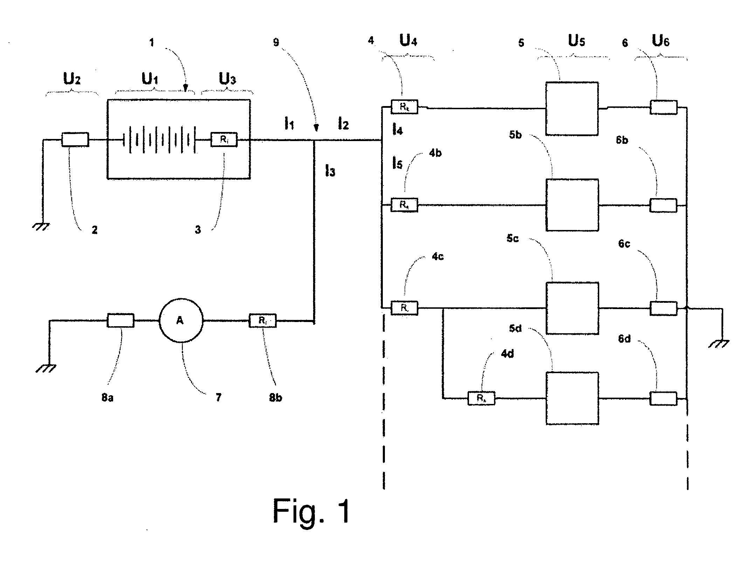

Voltages are measured over loads in the vehicle electrical system. An equivalent circuit diagram is based on the actual layout of the vehicle electrical system. An example equivalent circuit diagram is shown in figure 1. Using knowledge of static or dynamic worst case loads for e.g. vehicle safety critical sub-systems, such as e.g. electrically assisted power steering, braking etc, it is possible to e.g. predict if an internal combustion engine of the vehicle powering an alternator may be allowed to shut down for reducing emissions, or if charging of a low voltage battery from a high voltage battery may be interrupted, whilst maintaining battery capacity for any predictable worst case loads for vehicle critical sub-systems. Conversely, should a lack of low voltage battery capacity occur, means for generating electrical energy for replenishing the low voltage battery may be initiated, e.g. such as starting the internal combustion engine for powering an alternator/generator or commencing charging from the high voltage battery.

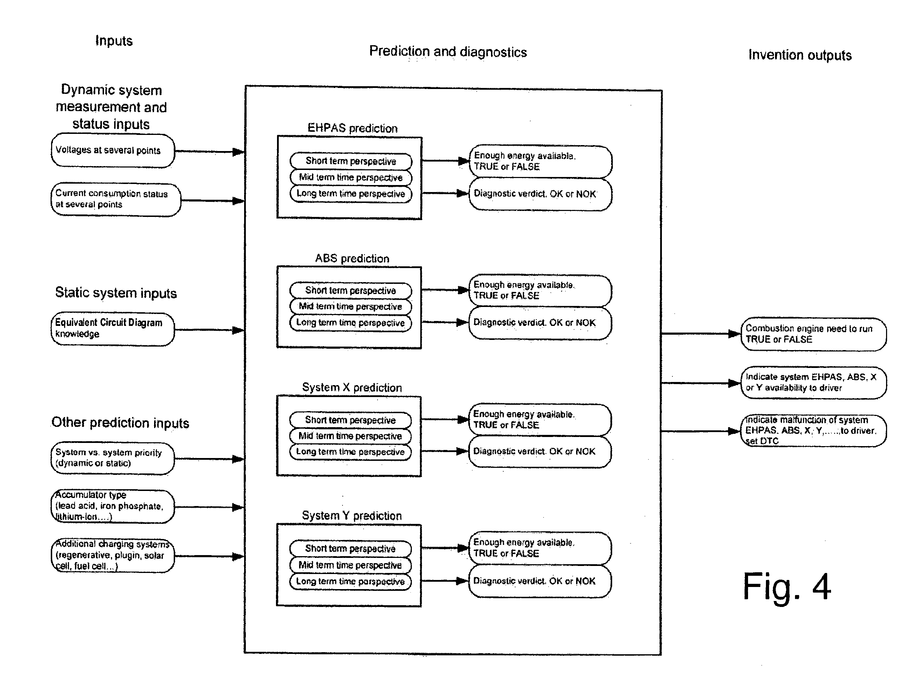

Modern vehicles have distributed electrical systems, the nodes of which communicate using data busses. If one or more nodes measures and transmit information on voltage and current consumption it is possible to centrally or locally determine if power supply and voltage levels are sufficient for activating a certain functionality and take measures for ensuring that the power supply and voltage levels are guaranteed. Through measuring at one or more loads a number of sources of errors are eliminated, such as resistance in the wiring and poor connections. It is also possible to perform diagnostic on included components or partial systems, as illustrated in figure 4 which is a block schematic illustrating how predictions for several partial systems are arranged and creates several composite signals out, which e.g. may be used to permit or deny stopping of the internal combustion engine and also provide availability and diagnosis information.

In accordance with the present invention an equivalent circuit diagram of the vehicle electrical system is employed and voltages are measured in one or more nodes, each serviced by an electronic control unit (ECU) having one or more loads activated. These measurements combined with knowledge of the vehicle electrical system enables a prediction of the energy status and voltage level at other combinations of loads. A diagnosis of the battery or batteries as well as the distribution system, such as wiring, connectors, etc., is part of the present invention.

It is irrelevant if an electric load is present in a node or controlled only by one node as long as the voltage feed to the load arrives via the node, i.e. the electric current passes through the node on its way to the load.

In the following will be described a specific embodiment of the method and arrangement in accordance with the present invention applied in a vehicle equipped with an Electro-Hydraulic Power-Assisted Steering (EHPAS) system.

In vehicles equipped with internal combustion engines having so called start-stop functionality, and also hybrid vehicles, there exist a possibility of reducing emissions from the internal combustion engine if it can be shut-down during operation, e.g. when stopping due to traffic congestion.

Another example where the internal combustion engine potentially may be shut-down is when travelling on downhill roads, where no propulsion of the vehicle by the internal combustion engine is required. In this natural mode of operation there exist potentially conflicting interests. If the vehicle is equipped with maneuvering and safety systems which are electrified and where loads, such as pumps and valves, for the functioning of these systems are powered by the energy reserve, a sufficient power supply level must be ensured in this energy reserve or the prerequisites be improved if possible.

An example of such systems is an Electro-Hydraulic Power-Assisted Steering (EHPAS) system, an Electro Power-Assisted Steering (EPAS) system, an Antilock Breaking System (ABS), a Traction Control System (TCS), a Dynamic Stability and Traction Control (DSTC) system. Other examples include electrically assisted brake systems, an electrically powered Air-Conditioner (AC) compressor of a climate control system, etc.

It is one object of the present invention to provide a method and an arrangement for predicting if the internal combustion engine may be allowed to shut-down or not or if a low voltage battery may be allowed to recharge from a high voltage battery, whilst ensuring sufficient electrical power supply for different vehicle systems electrically powered by a low voltage system, based on instantaneous and historical information.

In an EPHAS-system a common electrical current requirement at a steering maneuver lies in the vicinity of 100 amperes in a 12 volt system. At such current intensities it is particularly important that the power supply is sufficient all the way from the energy reserve to the load. A number of sources of error will affect this, such as the state (internal resistance) of the energy reserve (battery), its instantaneous charge status, wiring (including contactor transitions) for supply all the way to the EPHAS-system, fuse systems, connectors etc.

Of the above parameters one that may be affected during operation is the energy level of the energy reserve, and another circumstance that may be affected is whether to charge the energy reserve or not.

The ability to predict whether to maintain the internal combustion engine running, and thereby increase the charge level of the energy reserve, or to shut it down, which is desirable from an emission point of view, or to restart it if it has already been shut-down, is a method that may increase the probability that the EPHAS-system will be able to fulfill its function.

Likewise, the ability to predict whether to maintain charging of the energy reserve (low voltage battery) form the high voltage battery, or to interrupt charging, which is desirable from a range point of view, is also a method that may increase the probability that the EPHAS-system will be able to fulfill its function.

Should the combination of all parameters and modes of operation be unfavorable in respect of ascertaining a sufficient energy level for a particular system functionality a decision, based on several conditions, not to shut-down the internal combustion engine or more generalized not to interrupt charging may be taken, and thereby improve the energy level through producing electricity for replenishing the energy reserve from an alternator or from a high voltage battery.

For EPHAS there is a requirement that, in order to ensure that the driver experiences a normal torque at the steering wheel during a steering operation, the voltage to the electrical pump motor has to be at lest e.g. 10,5 volts.

In the above case security has been prioritized before exhaust emissions or range, however, it is more probable that this will occur as the vehicle or the energy reserve has aged, and is not a regular behavior.

What to prioritize may also be changed dynamically. Further examples of circumstances is an historical information regarding earlier energy usage by the EPHAS, i.e. if earlier, during the same or another driving cycle, a driver has maneuvered the vehicle such that the energy reserve has been heavily used, this will have an impact on the requirements for ensuring a steering maneuver if the vehicle later on travels on a downhill slope.

During all steering maneuvers information regarding desired energy usage and real available energy level may be saved in the EPHAS node. This then provides historical information which may be used at the next maneuver. Further, an estimate of the time required for increasing the energy level to a certain desired level may be part of a prediction.

In accordance with the present invention the probability of a partial system functioning properly is increased as several sources of error are eliminated. It is not only the energy level in the energy reserve which reflects the real probability of functioning.

The error sources also have different properties with respect to temperature. The internal resistance of a battery varies, e.g. usually decreases, with increased temperature and vice versa. The resistance of the wiring increases with increased temperature and vice versa. These are dynamic properties which render the total resistance at a certain temperature hard to calculate.

In accordance with the present invention the actual resistance is taken into account. Also other available charging systems, such as e.g. regenerative charging, not powered by an internal combustion engine, are taken into account by the present invention.

The present invention works in three temporal perspectives.

The first perspective is the short term perspective, in the magnitude of seconds, e.g. the instantaneous energy reserve. At an occasion when the driver steers the vehicle or applies the brakes of the vehicle a possibility presents itself to measure voltages at several nodes and their loads. Through measuring idle voltage and activation voltage a voltage difference is obtained, which together with the given system solution, i.e. how the electric power is distributed via the wiring, allows for predicting the voltage at a defined mode of operation, e.g. simultaneous activation of multiple loads.

Based on the above, prediction decisions can be made to either allow the activation of loads or to deactivate active loads. Another decision may be to activate charging, e.g. through starting the internal combustion engine and charge using the alternator, or to replenish a low voltage battery from a high voltage battery.

It is also possible to activate loads momentarily for testing the current status of the energy reserve including the distribution system. E.g. for EPHAS it is possible to perform a test through activating the pump to a higher power level than without an occurring steering maneuver. The purpose of the above test activation being to obtain a current status, in preparation of a possible activation of the steering, as compared to waiting until the driver performs the following normal activation of the steering.

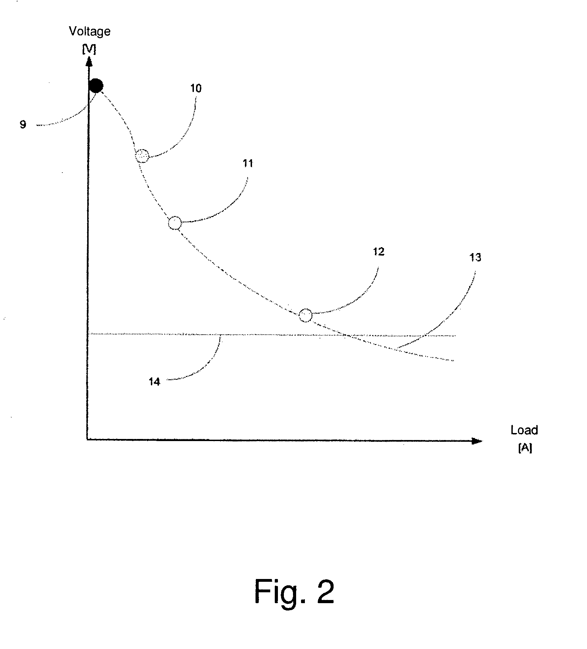

In figure 2 is shown an example of available voltage for e.g. EPHAS, starting from an un-loaded system state 9, where 10 and 11 are states when loads are activated in two steps, e.g. 10 represents a certain load from a number of partial loads and 11 an additional load. 10 and 11 thus represent different current consumptions and thus different available voltages. The voltage may e.g. be the voltage available for EPHAS. Here it is possible to predict the available voltage for e.g. a future steering maneuver using EPHAS, represented by an additional load in 12. The prediction then renders the available voltage for EPHAS with the load already activated in 10 and 11. A threshold value for available voltage is shown as a limit 14. The function load/available voltage may be likened to the curve 13. As shown in figure 2 the additional load 12 clears the available voltage limit 14.

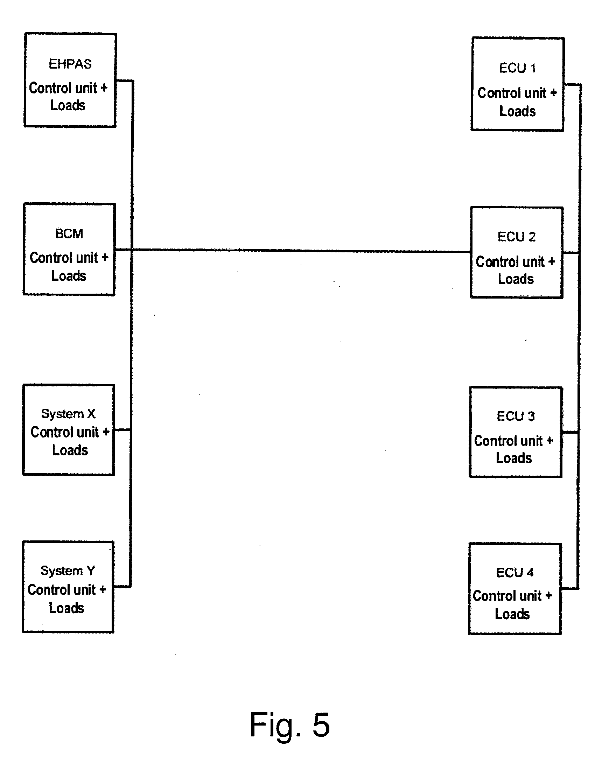

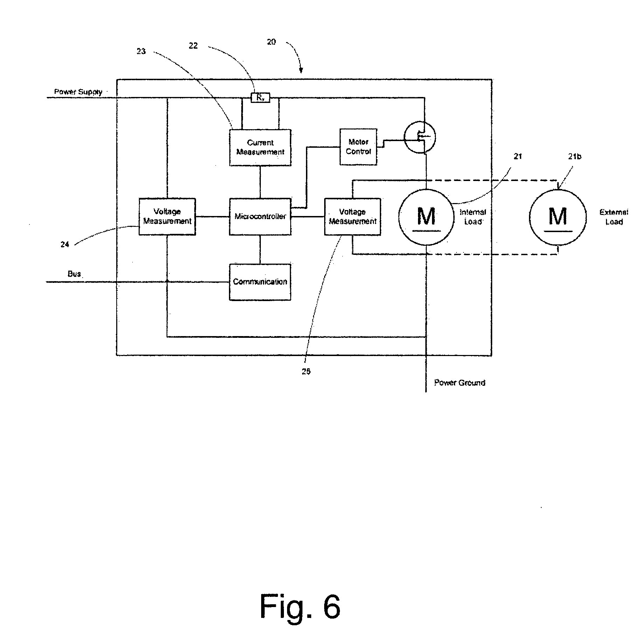

In a similar manner it is possible to perform predictions crosswise for other loads, e.g. a Break Control Module (BCM). As several loads may be activated independent of each other it is possible, as illustrated in figure 6 which shows how voltage and current consumption in a node is measured, by measuring in all nodes:
a. available voltage at an activated and a non-activated state, e.g. measured by 24 in node 20 as illustrated in figure 6.
b. activation status, i.e. instantaneous current consumption, e.g. measured by 23 in node 20 as illustrated figure 6,
and to exchange this information, via the communication bus shown in figure 6, between nodes, as illustrated in figure 5, which is an exemplary block schematic illustrating a communication bus system for transfer of information between nodes in a vehicle. Each node may then receive information from several other nodes and regarding several combinations of operational modes. Also, as it is known in advance how the wiring is designed, i.e. which junctions there are and where they are and which loads that are where, it is possible to perform a respective prediction for the own node or for other nodes. In figure 6 this is illustrated for internal load 21 and external load 21 b.

How to use several nodes own predictions for a decision to start/keep-operating the internal combustion engine or a decision to maintain/interrupt charging a low voltage battery from a high voltage battery may be concentrated to one node or a decision may be taken if at least one requires additional voltage, see figure 1. In figure 1 block 5 may represent the EPHAS ECU and loads, block 5b the BCM ECU and loads, block 5c a System X ECU and loads, and finally block 5d a System Y ECU and loads. Further in figure 1, the battery is designated 1 and its internal resistance 3. Voltages over components of the example equivalent circuit diagram of figure 1 are designated U_{N} and currents in the different wires of the example equivalent circuit diagram are designated I_{N} resistances in the example equivalent circuit diagram designated 2, 4, 4b, 4c, 4d, 6, 6b, 6c, 6d, 8a and 8b. Which resistances may be resistances in the wiring or represent loads. An example actuator is designated 7.

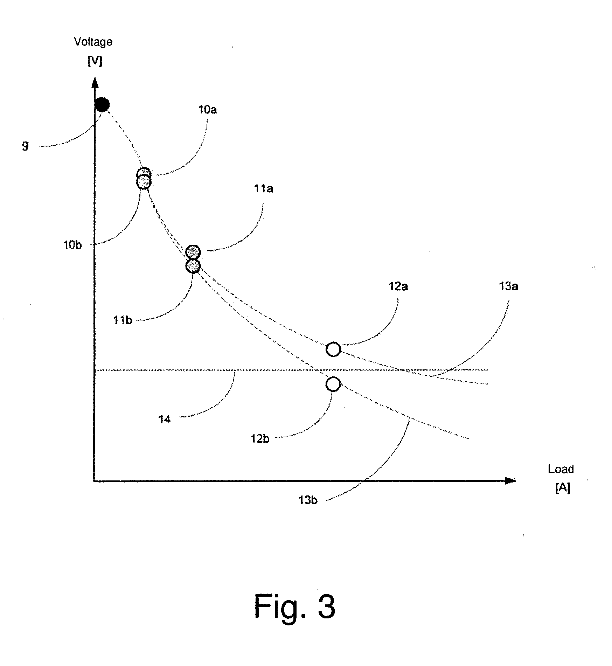

The second temporal perspective is a medium short perspective, in the magnitude of about an hour, e.g. load status. Using the load status of the energy reserve or state of charge (SOC) it is possible at a cold-start to measure the battery voltage, 9 in figure 3, without load in order to acquire a charge status value. The measurement is valid if the battery has not been charged for a certain time. This measurement may form the basis for determining if the alternator, powered by the internal combustion engine, may be allowed to shut down or not or if the charging of a low voltage battery from a high voltage battery may be allowed to be interrupted or not during an initial time period following start.

Thus, in figure 3 is shown an example of available voltage for e.g. EPHAS at cold start, starting from an un-loaded system state 9, where 10b and 11 b are states when loads are activated in two steps, e.g. 10b represents a certain load from a number of partial loads and 11 b an additional load. 10b and 11 b thus represent different current consumptions and thus different available voltages. The voltage may e.g. be the voltage available for EPHAS. Here it is possible to predict the available voltage for e.g. a future steering maneuver using EPHAS, represented by an additional load in 12b. The prediction then renders the available voltage for EPHAS with the load already activated in 10b and 11 b. A threshold value for available voltage is shown as a limit 14. The function load/available voltage may be likened to the curve 13b. The corresponding example from figure 2 is illustrated as loads 10a, 11 a and 12a and the corresponding curve 13a. As shown in figure 3 the additional load 12b falls below the available voltage limit 14.

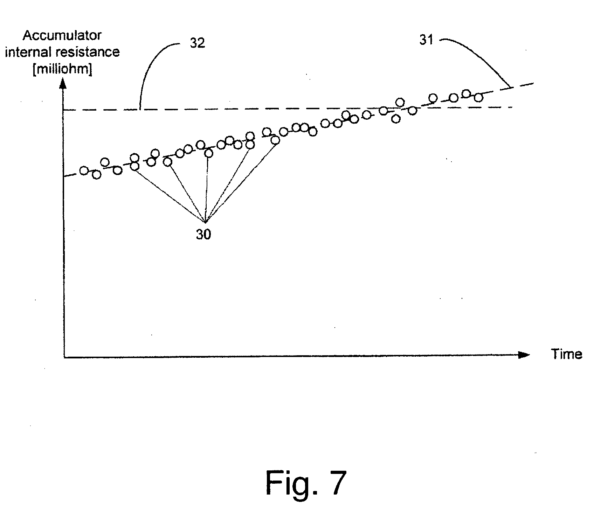

The third temporal perspective is the long term perspective, i.e. several years, which correspond to the ageing of the energy reserve and the distribution system. Here it is possible, e.g. through calculating a running average during a longer period of time, 31 in figure 7, e.g. one month, of the voltage from a number of measurements 30 on nodes having a certain load, to create an information which corresponds the ageing of the battery, i.e. the internal resistance. However, it should be noted that it will be virtually impossible to separate the resistance of the wiring from the internal resistance of the battery, i.e. to establish which one is possibly increasing.

The purpose of using the calculation of an average value is that a number of parameters change in the short term perspective, e.g. temperature, energy withdrawal, charge status etc.

When the calculated internal resistance 31 exceeds a threshold 32 a diagnostic information may be given the driver that the battery needs to be changed.

In order to differentiate this degradation from the degradation of the wiring, the unloaded voltage of the battery is used among other things. This information on ageing may be used for diagnostic purposes and may be indicated to the driver as a service message that the battery needs to be replaced. A prediction may even be made in advance that the replacement needs to be performed at a certain point in time in the future.

In accordance with the method for measuring and predicting available electrical power supply in vehicles, voltage is measured through each node having a stabilized voltage as a reference to the measured voltage of the node, that has been measured using an A/D converter. Current is measured either at a central location or in the respective node of the distributed system or a combination of both methods.

In vehicles lacking a system for charging which is active during operation, such as a Battery Electrical Vehicle, a decision regarding operation of an internal combustion engine cannot be made as above for the simple reason that there is no internal combustion engine. However, similar needs may still exist to be able to predict if the systems of the vehicle are able to perform their functions with a reasonable degree of security. A Battery Electrical Vehicle usually has a high voltage battery (e.g. 400V) for propelling of the vehicle and a low voltage battery (e.g. 12V) for operating different vehicle systems. In this case usually a DC/DC converter will be arranged between the high voltage battery and the low voltage battery in order to enable recharging of the low voltage battery from the high voltage battery, or vice versa. Use of a DC/DC converter implies losses. The present invention allows activating and charging using the DC/DC converter to be controlled and optimized. For example, one may wish to alert the driver that the probability that a certain system X will be available going forward has dropped under a certain level. Measurement of voltage may in this case also be performed on the electrical propulsion machinery.

Further, other vehicles having multiple systems, such as hybrids between hydrogen powered and electrically powered vehicles, fuel-cell electrical vehicles or other types of hybrid vehicles having a high voltage battery and a low voltage battery, etc. may also benefit from the present invention.

In the following a schematic description of the algorithm predicting the short-term available energy status of the vehicle electric system (referred to as the algorithm) will be given. The algorithm is used for predicting energy status for battery and electrical sub systems.

The main function of the algorithm is to model the complete electric system outside the ECU as a linear circuit with an ideal battery with voltage V and a serial resistance R. Then, by monitoring the ECU voltage and electrical current (including the load controlled by the ECU) the model control variables (V and R) may be continuously calculated.

Calculation of the model control variables shall be robust and withstand common noise such as PWM related noise, limited resolution, etc. This can be done using least squares methods, working with any number of samples, or any similar statistical method. The current and voltage sampling may be optimized, concerning sample frequency and number of samples, to maximize the accuracy within an acceptable estimation time. One may also use at least one of a running least squares method or a running average method or polynomial approximations, where new samples are weighted compared to older samples.

The algorithm uses the calculated model control variables to extrapolate the ECU voltage at present current to a current Iₘₐₓ corresponding to a defined heavy load scenario. The extrapolated voltage at the ECU will then suffer a voltage drop. If the extrapolated voltage at the ECU drops below a certain acceptance threshold, the algorithm triggers a control signal. The control signal may be used to initiate charging of the vehicle battery.

The algorithm continues to be active although the acceptance threshold is passed, providing a continuous system monitoring. The closer to the heavy load scenario current the actual current is the better estimation of the corresponding voltage drop.

Hence, the main function of the algorithm is to determine whether or not the vehicle battery and the electric system can deliver a certain current at a minimum ECU voltage during a limited period.

The algorithm is active while charging of the battery is disabled and the battery is the main energy source. Capacitive effects of a recently charged battery, affecting the battery properties, may be avoided by delaying the algorithm start, depending on the battery type and capacitance.

The algorithm may be used in several ECU:s in the same vehicle, thus providing several independent predictions and alarm or control triggers, which may be used not only to trigger a charging device (an alternator driven by combustion engine, a DC/DC converter connected to a second source of electrical energy in an electric or hybrid car or any other type of charging device) but also to estimate the quality of parts of the electric system, such as cable- or contact resistances, or the battery quality and age.

Thus, in accordance with the present invention, a method for measuring and predicting available electrical power supply in vehicles having one or more electronic control units and associated electrical systems, comprises the steps of: modeling the complete electrical system outside the electronic control unit as a linear circuit with an ideal battery with voltage V and a serial resistance R; monitoring the electronic control unit voltage and electrical current including the loads controlled by the electronic control unit; continuously calculating the model control variables V and R using the monitored voltage and current; using the calculated model control variables V and R to extrapolate the electronic control unit voltage at present current Iₚᵣₑₛ to a current Iₘₐₓ corresponding to a predefined heavy load scenario; triggering a control signal if the extrapolated electronic control unit voltage drops below a certain acceptance threshold.

In a further embodiment of the method the complete electrical system outside the electronic control unit is modeled as an equivalent circuit diagram.

In a yet further embodiment of the method the model control variables V and R are continuously calculated using least squares methods working with any number of samples of the monitored voltage and current. Alternatively, at least one of a running least squares method or a running average method or polynomial approximations is used where new samples are weighted higher compared to older samples.

In a still further embodiment of the method the triggered control signal is used to initiate charging of a vehicle battery.

The above steps may be realized using hardware, software and/or a combination thereof and may be centralized to a central processing unit in the vehicle or alternatively distributed between the nodes of the vehicle electrical system, e.g. between the respective ECU:s of the vehicle electrical system and coordinated over a vehicle communication bus.

The present invention also relates to an arrangement for measuring and predicting available electrical power supply in vehicles having one or more electronic control units and associated electrical systems, which comprises means for: modeling the complete electrical system outside the electronic control unit as a linear circuit with an ideal battery with voltage V and a serial resistance R; monitoring the electronic control unit voltage and electrical current including the loads controlled by the electronic control unit; continuously calculating the model control variables V and R using the monitored voltage and current; using the calculated model control variables V and R to extrapolate the electronic control unit voltage at present current Iₚᵣₑₛ to a current Iₘₐₓ corresponding to a predefined heavy load scenario; triggering a control signal if the extrapolated electronic control unit voltage drops below a certain acceptance threshold.

In a further embodiment the arrangement further comprises means for modeling the complete electrical system outside the electronic control unit is as an equivalent circuit diagram.

In a yet further embodiment the arrangement further comprises means for continuously calculating the model control variables V and R using least squares methods working with any number of samples of the monitored voltage and current. Alternatively, the arrangement further comprises means for using at least one of a running least squares method or a running average method or polynomial approximations where new samples are weighted higher compared to older samples.

In a still further embodiment the arrangement further comprises means for using the triggered control signal to initiate charging of a vehicle battery.

The above means may be realized in hardware, software and/or a combination thereof and may be centralized to a central processing unit in the vehicle or alternatively distributed between the nodes of the vehicle electrical system, e.g. between the respective ECU:s of the vehicle electrical system and coordinated over a vehicle communication bus.

The present invention also relates to a vehicle comprising an arrangement for measuring and predicting available electrical power supply in vehicles having one or more electronic control units and associated electrical systems as described above.

The invention is not limited to the above-described embodiments, but may be varied within the scope of the following claims.

## Claims

1. Method for measuring and predicting available electrical power supply in vehicles having one or more electronic control units and associated electrical systems, **characterized in that** it comprises the steps of:
modeling the complete electrical system outside the electronic control unit as a linear circuit with an ideal battery with voltage V and a serial resistance R;
monitoring the electronic control unit voltage and electrical current including the loads controlled by the electronic control unit;
continuously calculating the model control variables V and R using the monitored voltage and current;
using the calculated model control variables V and R to extrapolate the electronic control unit voltage at present current Iₚᵣₑₛ to a current Iₘₐₓ corresponding to a predefined heavy load scenario;
triggering a control signal if the extrapolated electronic control unit voltage drops below a certain acceptance threshold.

2. Method according to claim 1, **characterized in that** the complete electrical system outside the electronic control unit is modeled as an equivalent circuit diagram.

3. Method according to any one of claims 1 or 2, **characterized in that** the model control variables V and R are continuously calculated using least squares methods or any similar statistical method working with any number of samples of the monitored voltage and current.

4. Method according to claim 3, **characterized in that** at least one of a running least squares method or a running average method or polynomial approximations is used where new samples are weighted higher compared to older samples.

5. Method according to any one of claims 1 to 4, **characterized in that** the triggered control signal is used to initiate charging of a vehicle battery.

6. Arrangement for measuring and predicting available electrical power supply in vehicles having one or more electronic control units and associated electrical systems, **characterized in that** it comprises means for:
modeling the complete electrical system outside the electronic control unit as a linear circuit with an ideal battery with voltage V and a serial resistance R;
monitoring the electronic control unit voltage and electrical current including the loads controlled by the electronic control unit;
continuously calculating the model control variables V and R using the monitored voltage and current;
using the calculated model control variables V and R to extrapolate the electronic control unit voltage at present current Iₚᵣₑₛ to a current Iₘₐₓ corresponding to a predefined heavy load scenario;
triggering a control signal if the extrapolated electronic control unit voltage drops below a certain acceptance threshold.

7. Arrangement according to claim 6, **characterized in that** it further comprises means for modeling the complete electrical system outside the electronic control unit is as an equivalent circuit diagram.

8. Arrangement according to any one of claims 6 or 7, **characterized in that** it further comprises means for continuously calculating the model control variables V and R using least squares methods or any similar statistical method working with any number of samples of the monitored voltage and current.

9. Arrangement according to claim 8, **characterized in that** it further comprises means for using at least one of a running least squares method or a running average method or polynomial approximations where new samples are weighted higher compared to older samples.

10. Arrangement according to claim 6, **characterized in that** it further comprises means for using the triggered control signal to initiate charging of a vehicle battery.

11. A vehicle, **characterized in that** it comprises an arrangement for measuring and predicting available electrical power supply in vehicles having one or more electronic control units and associated electrical systems in accordance with any one of claims 6 to 10.

## Patentansprüche

1. Verfahren zum Messen und Vorhersagen einer verfügbaren Stromversorgung in Fahrzeugen, die eine oder mehrere elektronische Steuereinheiten und zugeordnete elektrische Systeme aufweisen, **dadurch gekennzeichnet, dass** es die folgenden Schritte aufweist:
Modellieren des vollständigen elektrischen Systems außerhalb der elektronischen Steuereinheit als eine lineare Schaltung mit einer idealen Batterie mit einer Spannung V und einem Serienwiderstand R; Überwachen der Spannung und des elektrischen Stroms der elektronischen Steuereinheit einschließlich der Lasten, die von der elektronischen Steuereinheit gesteuert werden;
kontinuierliches Berechnen der Modell-Steuervariablen V und R unter Verwendung der überwachten Spannung und des überwachten Stroms;
Verwenden der berechneten Modell-Steuervariablen V und R, um die Spannung der elektronischen Steuereinheit bei einem gegenwärtigen Strom Iₚᵣₑₛ für einen Strom Iₘₐₓ zu extrapolieren, der einem vordefinierten Schwerlast-Szenario entspricht;
Auslösen eines Steuersignals, falls die extrapolierte Spannung der elektronischen Steuereinheit unter einen gewissen Akzeptanzschwellenwert absinkt.

2. Verfahren nach Anspruch 1, **dadurch gekennzeichnet, dass** das vollständige elektrische System außerhalb der elektronischen Steuereinheit als ein äquivalenter Schaltplan modelliert wird.

3. Verfahren nach einem der Ansprüche 1 oder 2, **dadurch gekennzeichnet, dass** die Modell-Steuervariablen V und R kontinuierlich unter Anwendung von Methoden der kleinsten Quadrate oder eines beliebigen ähnlichen statistischen Verfahrens, das mit einer beliebigen Anzahl von Abtastwerten der überwachten Spannung und des überwachten Stroms arbeitet, berechnet werden.

4. Verfahren nach Anspruch 3, **dadurch gekennzeichnet, dass** eine Methode der gleitenden kleinsten Quadrate und/oder eine Methode der gleitenden Durchschnitte und/oder polynomiale Approximationen angewendet werden, wobei neue Abtastwerte im Vergleich zu älteren Abtastwerten höher gewichtet werden.

5. Verfahren nach einem der Ansprüche 1 bis 4, **dadurch gekennzeichnet, dass** das ausgelöste Steuersignal verwendet wird, um das Laden einer Fahrzeugbatterie zu initiieren.

6. Anordnung zum Messen und Vorhersagen einer verfügbaren Stromversorgung in Fahrzeugen, die eine oder mehrere elektronische Steuereinheiten und zugeordnete elektrische Systeme aufweisen, **dadurch gekennzeichnet, dass** sie Mittel aufweist zum:
Modellieren des vollständigen elektrischen Systems außerhalb der elektronischen Steuereinheit als eine lineare Schaltung mit einer idealen Batterie mit einer Spannung V und einem Serienwiderstand R; Überwachen der Spannung und des elektrischen Stroms der elektronischen Steuereinheit einschließlich der Lasten, die von der elektronischen Steuereinheit gesteuert werden;
kontinuierliches Berechnen der Modell-Steuervariablen V und R unter Verwendung der überwachten Spannung und des überwachten Stroms;
Verwenden der berechneten Modell-Steuervariablen V und R, um die Spannung der elektronischen Steuereinheit bei einem gegenwärtigen Strom Iₚᵣₑₛ für einen Strom Iₘₐₓ zu extrapolieren, der einem vordefinierten Schwerlast-Szenario entspricht;
Auslösen eines Steuersignals, falls die extrapolierte Spannung der elektronischen Steuereinheit unter einen gewissen Akzeptanzschwellenwert absinkt.

7. Anordnung nach Anspruch 6, **dadurch gekennzeichnet, dass** sie ferner Mittel zum Modellieren des vollständigen elektrischen Systems außerhalb der elektronischen Steuereinheit als ein äquivalenter Schaltplan aufweist.

8. Anordnung nach einem der Ansprüche 6 oder 7, **dadurch gekennzeichnet, dass** sie ferner Mittel zum kontinuierlichen Berechnen der Modell-Steuervariablen V und R unter Anwendung von Methoden der kleinsten Quadrate oder eines beliebigen ähnlichen statistischen Verfahrens, das mit einer beliebigen Anzahl von Abtastwerten der überwachten Spannung und des überwachten Stroms arbeitet, aufweist.

9. Anordnung nach Anspruch 8, **dadurch gekennzeichnet, dass** sie ferner Mittel zum Anwenden einer Methode der gleitenden kleinsten Quadrate und/oder einer Methode der gleitenden Durchschnitte und/oder polynomialer Approximationen, wobei neue Abtastwerte im Vergleich zu älteren Abtastwerten höher gewichtet werden, aufweist.

10. Anordnung nach Anspruch 6, **dadurch gekennzeichnet, dass** sie ferner Mittel zum Verwenden des ausgelösten Steuersignals, um das Laden einer Fahrzeugbatterie zu initiieren, aufweist.

11. Fahrzeug, **dadurch gekennzeichnet, dass** es eine Anordnung zum Messen und Vorhersagen einer verfügbaren Stromversorgung in Fahrzeugen, die eine oder mehrere elektronische Steuereinheiten und zugeordnete elektrische Systeme aufweisen, nach einem der Ansprüche 6 bis 10 aufweist.

## Revendications

1. Procédé de mesure et de prévision d'une alimentation électrique disponible dans des véhicules ayant une ou plusieurs unités de commande électroniques et des systèmes électriques associés, **caractérisé en ce qu'**il comprend les étapes consistant à :
modéliser l'ensemble du système électrique à l'extérieur de l'unité de commande électronique sous la forme d'un circuit linéaire avec une batterie idéale avec une tension V et une résistance en série R ;
surveiller la tension et le courant électrique de l'unité de commande électronique comprenant les charges commandées par l'unité de commande électronique ;
calculer en continu les variables de commande de modèle V et R à l'aide de la tension et du courant surveillés ;
utiliser les variables de commande de modèle V et R calculées pour extrapoler la tension de l'unité de commande électronique au courant actuel Iₚᵣₑₛ en un courant Iₘₐₓ correspondant à un scénario de charge lourde prédéfini ;
déclencher un signal de commande si la tension de l'unité de commande électronique extrapolée baisse en dessous d'un certain seuil de réception.

2. Procédé selon la revendication 1, **caractérisé en ce que** l'ensemble du système électrique placé à l'extérieur de l'unité de commande électronique est modélisé sous la forme d'un schéma de circuits équivalent.

3. Procédé selon l'une quelconque des revendications 1 ou 2, **caractérisé en ce que** les variables de commande de modèle V et R sont calculées en continu à l'aide des procédés des moindres carrés ou n'importe quel autre procédé statistique similaire fonctionnant avec n'importe quel nombre d'échantillons de tension et de courant surveillés.

4. Procédé selon la revendication 3, **caractérisé en ce qu'**au moins un procédé parmi un procédé des moindres carrés constants ou un procédé de moyenne constante ou des approximations polynomiales est utilisé lorsque les nouveaux échantillons pesés sont plus lourds que les anciens échantillons.

5. Procédé selon l'une quelconque des revendications 1 à 4, **caractérisé en ce que** le signal de commande déclenché est utilisé pour lancer le chargement d'une batterie de véhicule.

6. Agencement de mesure et de prévision d'alimentation électrique disponible dans des véhicules ayant une ou plusieurs unités de commande électroniques et des systèmes électriques associés, **caractérisé en ce qu'**il comprend des moyens permettant de :
modéliser l'ensemble du système électrique à l'extérieur de l'unité de commande électronique sous la forme d'un circuit linéaire avec une batterie idéale avec une tension V et une résistance en série R ;
surveiller la tension et le courant électrique de l'unité de commande électronique comprenant les charges commandées par l'unité de commande électronique ;
calculer en continu les variables de commande de modèle V et R à l'aide de la tension et du courant surveillés ;
utiliser les variables de commande de modèle V et R calculées pour extrapoler la tension de l'unité de commande électronique au courant actuel Iₚᵣₑₛ en un courant Iₘₐₓ correspondant à un scénario de charge lourde prédéfini ;
déclencher un signal de commande si la tension de l'unité de commande électronique extrapolée baisse en dessous d'un certain seuil de réception.

7. Agencement selon la revendication 6, **caractérisé en ce qu'**il comprend en outre des moyens de modélisation de l'ensemble du système électrique à l'extérieur de l'unité de commande électronique sous la forme d'un schéma de circuits équivalent.

8. Agencement selon l'une quelconque des revendications 6 ou 7, **caractérisé en ce qu'**il comprend en outre des moyens de calcul en continu des variables de commande de modèle V et R à l'aide des procédés des moindres carrés ou de n'importe quel autre procédé statistique similaire fonctionnant avec n'importe quel nombre d'échantillons de tension et de courant surveillés.

9. Agencement selon la revendication 8, **caractérisé en ce qu'**il comprend en outre des moyens permettant d'utiliser au moins un procédé parmi un procédé des moindres carrés constants ou un procédé de moyenne constante ou des approximations polynomiales lorsque les nouveaux échantillons pesés sont plus lourds que les anciens échantillons.

10. Agencement selon la revendication 6, **caractérisé en ce qu'**il comprend en outre des moyens permettant d'utiliser le signal de commande déclenché pour lancer le chargement d'une batterie de véhicule.

11. Véhicule, **caractérisé en ce qu'**il comprend un agencement de mesure et de prévision de l'alimentation électrique disponible dans des véhicules dotés d'une ou de plusieurs unités de commande électroniques et de systèmes électriques associés selon l'une quelconque des revendications 6 à 10.
